# EUROPEAN PATENT APPLICATION

(11) **EP 4 810 439 A1**
(43) Date of publication of application: **23.09.2026**
(21) Application number: 25861687.9
(22) Date of filing: 01.04.2025
(51) Int. Cl.: B81B 7/02

(54) **VACUUM MICROCAVITY INTERFEROMETER CHIP, MANUFACTURING METHOD AND ULTRA-HIGH-PRECISION OPTICAL PRESSURE SENSOR**

(30) Priority: 13.01.2025 CN 202510045360
(71) Applicant: Shanghai Baiantek Sensing Technology Co., Ltd., Shanghai 201210 (CN); Shanghai Baiantek Semiconductor Co., Ltd., Shanghai 201816 (CN)
(72) Inventor: ZHONG, Shaolong, Shanghai 201201 (CN); LONG, Liang, Shanghai 201201 (CN); GUO, Zhihui, Shanghai 201201 (CN); LI, Haosibaiyin, Shanghai 201201 (CN)
(74) Representative: Elzaburu S.L.P.
(86) International application number: PCT/CN2025/086742
(87) International publication number: WO 2026/148739

(57) **Abstract**

The present application relates to a vacuum microcavity interferometer chip, a manufacturing method, and an ultrahigh-precision optical pressure sensor. According to the present application, a concave cavity is etched in a lower surface of a first substrate, when the first substrate and a second substrate are bonded, the concave cavity is formed as an F-P interference cavity, a first reflective surface is arranged on a surface, in the F-P interference cavity, of the first substrate, a second reflective surface is arranged on a surface, in the F-P interference cavity, of the second substrate, an annular cavity is formed in an upper surface of a third substrate, getter films are deposited on at least one surface in the annular cavity, at least one vent hole is formed in the second substrate, and the vent hole communicates with the F-P interference cavity and the annular cavity; and projections of the annular cavity and the F-P interference cavity on a horizontal plane at least partially overlap.

## Description

### TECHNICAL FIELD

The present disclosure relates to sensors in the technical field of optoelectronics, in particular to a vacuum microcavity interferometer chip based on the principle of a vacuum microcavity multi-beam interferometer, a manufacturing method, and an ultrahigh-precision optical pressure sensor. The sensor is mainly intended for measuring pressure of fluid media such as gases and liquids, and can also be applied to the measurement and control of parameters including flow rate, flow velocity, density, liquid level, altitude, and contact acting force between objects.

### BACKGROUND ART

Pressure sensors refer to devices or equipment that can sense pressure signals of fluid media such as gases and liquids, and convert the pressure signals into usable output electric or optical signals according to a predetermined rule. The pressure sensors are one of the most commonly used sensors in industrial practice, which are widely applied in various industrial automatic control environments such as water conservancy and hydropower, railway transportation, Intelligent building, production automation, aerospace, military industry, petrochemicals, oil wells, power, ships, machine tools, pipelines, etc. and also been increasingly widely applied in the fields of consumer electronics such as medical equipment, robots and automotive electronics, smart phones, smart home appliances and wearable electronic products.

The product selling price of the pressure sensors mainly depends on applicable usage conditions and measurement precision that can be maintained for a long time. Industrial-grade pressure sensors with an operating temperature range of -55°C to 85°C and a precision of 0.01%, as well as sensors with temperature resistance exceeding 200°C and 0.1% precision across the entire temperature range, each cost several thousand to tens of thousands of yuan RMB. Pressure sensors with wide temperature ranges, high precision, and high reliability have strong demand in multiple fields such as nuclear power, aerospace, railway transportation, semiconductor equipment and process industries. The pressure sensors can be classified according to detection methods, such as electrical detection pressure sensors and optical detection pressure sensors. At present, among the electrical detection pressure sensors, resonant pressure sensors have been widely recognized by the market due to a series of advantages such as high temperature stability, high long-term stability, and high overall accuracy. However, the application of the resonant pressure sensors in high-temperature environments or occasions with radiation and electromagnetic interference is restricted. Optical fiber pressure sensors can meet the usage requirements in such occasions. An optical fiber sensing technology is a new technology that developed rapidly in the late 1970s, which is the application of fiber optics in non-communication fields. The optical fiber sensing technology can measure over a hundred types of physical quantities. It has the advantages of wide application range, high sensitivity, resistance to electromagnetic interference, good insulation, corrosion resistance, flexibility, compact size, low cost, and good compatibility with optical fiber transmission lines.

An optical fiber F-P (Fabry-Perot) pressure sensor is one type of optical fiber pressure sensor. Usually, a Fabry-Perot micro-resonant cavity is formed by an optical fiber end face and a diaphragm end face. When pressure acts on a pressure sensitive film, the pressure sensitive film deforms, resulting in a change in the cavity length of the Fabry-Perot, thereby achieving sensing and measurement. The optical fiber Fabry-Perot pressure sensor is simple in structure and easy to implement. It is the most commonly used interferometric optical fiber pressure sensor currently. Pressure sensitive films of some sensors are prepared using a micro-electromechanical system (MEMS) bulk silicon process and a surface sacrificial layer process. Pressure sensitive films of some other sensors are prepared by using an optical fiber corrosion welding process. MEMS optical fiber pressure sensors combine the advantages of miniaturization, high reliability, and high consistency of an MEMS technology and the advantages of an optical fiber signal readout technology, significantly expanding the application range of high-precision pressure sensors. High-precision MEMS optical fiber sensors typically adopt wavelength demodulation methods, especially an F-P optical interference cavity (Fabry-Perot) interference type. A working principle thereof is to integrate a pressure sensitive film with an F-P optical interference cavity. The pressure sensitive film is bent under external pressure, the length of the F-P optical interference cavity synchronously changes, and the interference wavelength thereof also changes. The change in the wavelength is read out through an optical fiber, thereby measuring the external pressure. For specific details, please refer to the Chinese patent application CN201410728291.6 in the prior art, which discloses the measurement of pressure using an F-P optical interference cavity. This sensor has a film-island structure arranged in the F-P optical interference cavity. The inwardly oriented film-island structure increases the volume of the F-P optical interference cavity and further increases the arrangement area of required getter films. At the same time, the inwardly oriented film-island structure has a limited height due to the spatial constraints imposed by the F-P optical interference cavity, resulting in the requirements for high light transmittance of an optical anti-reflection film arranged thereon, which increases the cost of a sensitive chip. In addition, the inwardly oriented film-island structure cannot be further processed after the sensitive chip is connected in bonded manner, and parameters of the sensitive chip cannot be adjusted.

Since the dynamic detection resolution of a multi-beam F-P interferometer for the cavity length can reach 1 pm to 10 pm, while the dynamic detection resolution of a dual-beam F-P interferometer for the cavity length can only reach the order of 100 pm to 1 nm, and therefore the sensitivity of the pressure sensor can be greatly improved by constructing the multi-beam F-P interferometer in a pressure sensitive chip. However, during the construction of the multi-beam F-P interferometer, optical films need to be deposited to enhance the optical reflectivity of two reflective surfaces of the F-P interferometer. Moreover, there are extremely high requirements for the parallelism and cleanliness of the two reflective surfaces, only in this way can laser signals incident in the cavity be maintained to undergo hundreds of reflections between the two reflective surfaces, thereby meeting basic conditions of multi-wavelength interference. Due to the temperature limit of 500°C to 600°C of the optical films, the optical films of the reflective surfaces of the multi-beam F-P interferometer inside the MEMS chip can be kept intact only by adopting a silicon-glass bonding process within the temperature range of 300°C to 400°C. However, gas emitted by silicon-glass bonding can cause decrease in the vacuum degree of an interference cavity inside the multi-beam F-P interferometer and introduce unstable refractive indexes, affecting the low-pressure measurement range and zero-point stability of the MEMS pressure sensitive chip. Moreover, it will also increase the temperature coefficient and reduce the measurement repeatability. In order to achieve high-precision pressure measurement, this type of sensor usually requires vacuuming the interior of the F-P optical interference cavity, and the vacuum degree needs to keep stable. Usually, some residual gas will remain in the cavity during the manufacturing process. Therefore, it is necessary to seal a getter in the vacuum chamber and activate the getter during the manufacturing process of the sensor to absorb the residual gas in the F-P optical interference cavity, achieving high vacuum inside the pressure sensor. Chinese patent application CN20121017590.0 discloses an MEMS chip packaging structure. Usually, a getter is deposited inside an F-P optical interference cavity by physical vapor deposition (PVD). To ensure that the residual gas is absorbed completely, the getter usually occupies a relatively large area. Therefore, when the range of the sensor is increased by reducing the area of the pressure sensitive film, the limitation imposed by the getter area becomes a constraining factor. In addition, the getter is of a porous structure, with poor density. When the getter is heated or vibrated externally, particles will be generated, which will contaminate the F-P optical interference cavity and potentially lead to spectral deterioration, greatly affecting the measurement of the optical sensor, especially causing device failure in severe cases. Getter films arranged radially in the sensor are not conducive to minimizing the radial dimension of the sensor. In some specific application scenarios, a sensor chip with a smaller radial dimension is required, such that the sensor chip can be arranged in a hole with a smaller diameter. Chinese patent application CN201410264998.6 relates to a hybrid wafer-level vacuum packaging method. Getter cavities are formed in a side of a chip packaging cavity and communicated through vent holes, and covers are fixed after a getter is fixed to the getter cavities. This structure and method also have the potential for the getter to contaminate an F-P optical interference cavity. Moreover, in this method, the getter cavities and getter are superimposed after a chip is formed, such that the manufacturing process is complex. Moreover, there is a certain possibility that getter particles enter a working cavity through vent hole passages. The getter particles have a certain insulating property and have a relatively small impact on electrical detection sensors.

In addition, after an MEMS pressure sensitive chip and an optical fiber are coupled and packaged into an MEMS optical pressure module, secondary packaging is usually required for fixing the module to a pressure sensor housing, so as to achieve sealed pressure extraction, module measurement, isolation and protection of an outgoing cable and become an MEMS optical pressure sensor that can be independently mounted and used. During secondary packaging of a structure of a sensitive chip recited in CN201410728291.6, a multi-beam F-P interferometer will be subject to uneven stress whether external mechanical force from a housing is conducted to the MEMS pressure-sensitive chip or to a welding and packaging position between the MEMS pressure sensitive chip and an optical fiber, resulting in the deterioration of an interference spectrum, and measured values will change abnormally.

### SUMMARY

The present disclosure provides a vacuum microcavity interferometer chip, a manufacturing method, and an ultrahigh-precision optical pressure sensor to overcome the technical defects of optical fiber pressure sensors in the prior art. The vacuum microcavity interferometer chip includes a first substrate, a second substrate, and a third substrate. Preferably, the first substrate and the third substrate are silicon substrates or silicon nitride wafers or substrates with other similar functions, the second substrate is a glass wafer or a sapphire wafer or a substrate with other similar functions and high light transmittance, and the three substrates are bonded together through silicon-glass-silicon bonding or corresponding dielectric layers, such as benzocyclobutene (BCB) glue, gold layers or glass paste. A concave cavity is formed in a lower surface of the first substrate by etching, after the first substrate and the second substrate are bonded together, the concave cavity is formed as an F-P interference cavity, a first reflective surface is arranged on a surface, in the F-P interference cavity, of the first substrate, a second reflective surface is arranged on a surface, in the F-P interference cavity, of the second substrate, an annular cavity is formed in the third substrate, a getter film is deposited on at least one surface in the annular cavity, at least one vent hole is formed in the second substrate, and the vent hole communicates with the F-P interference cavity and the annular cavity; the projections of the annular cavity and the F-P interference cavity on a horizontal plane at least partially overlap each other; and a mounting hole for an optical fiber collimator is formed in the center of the third substrate. By means of the above structure, the annular cavity is connected with the F-P interference cavity through the vent hole(s), such that the annular cavity where the getter films are deposited is independently formed, thereby ensuring that the annular cavity has enough surface area to absorb residual gas in the F-P optical interference cavity. In addition, since the annular cavity and the F-P interference cavity are not arranged on the same substrate, the projections of the annular cavity and the F-P interference cavity in this structure on the horizontal plane at least partially overlap, thereby reducing the radial dimension of the vacuum microcavity interferometer chip and meeting mounting requirements of special application scenarios. It is also ensured that the area of the pressure sensitive film in the chip with the same radial dimension is large enough during pressure measurement, gas in the F-P optical interference cavity is gettered, the precision of the sensor during pressure measurement is improved, and therefore the requirements for ultrahigh-precision pressure measurement are met.

Preferably, a width of the annular cavity is greater than a diameter of the vent holes, such that a small quantity of particles will be generated when the getter films are heated or vibrated externally, the particles are blocked by the second substrate, and the situation that the particles enter the F-P interference cavity through the vent holes to contaminate the F-P optical interference cavity and potentially lead to spectral deterioration, greatly affecting the measurement of the optical sensor, especially causing device failure in severe cases is avoided.

Preferably, a first accommodating space is formed at a position, corresponding to the vent holes, of the annular cavity, the first accommodating space is a deposition groove formed in a bottom of the annular cavity and used for accommodating a small quantity of particles formed by the getter films, and a depth of the first accommodating space is greater than that of the annular cavity, so as to further prevent the particles from entering the F-P interference cavity through the vent holes.

Preferably, a sunken groove is formed in an opening of the annular cavity, the sunken groove has a circular structure, and the sunken groove cooperates with the bottom surface of the first substrate to form a second accommodating space. When the vacuum microcavity interferometer chip is subject to vibration and/or inclining during use, since the diameter of the vent holes is less than the width of the annular cavity, the particles move towards the vent holes along a side wall of the first accommodating space, and are blocked by a bottom face of the second substrate to enter the second accommodating space, and the situation that the particles enter the F-P interference cavity through the vent holes, affecting beams of the F-P interference cavity, resulting in inaccurate measurement is further avoided.

Preferably, the annular cavity includes two peripheral walls and a bottom wall, at least one peripheral wall of the annular cavity inclines, a bottom width of the annular cavity is less than an opening width of the annular cavity since the peripheral walls incline, and the inclined peripheral wall increases a difference between the diameter of the vent hole and the opening width of the annular cavity. Therefore, the particles can be better prevented from entering the vent holes from the annular cavity, and meanwhile the particles can be better guided to enter the second accommodating space.

Preferably, the side wall of the first accommodating space and the two peripheral walls of the annular cavity are smoothly and continuously connected, and the particles can be directly guided into the second accommodating space by the smooth and continuous side wall and peripheral walls.

Preferably, a step portion is arranged on the second substrate, a diameter of the step portion is greater than that of the vent holes, and the step portion is arranged between the vent holes and the annular cavity. By using the diameter change in the step portion and the vent holes, a trace quantity of particles stored in the first accommodating space and the second accommodating space are blocked, further being prevented from entering the F-P interference cavity.

Preferably, a film-island structure is formed on an upper surface of the first substrate, the film-island structure includes a protruding portion formed by a counterbored hole and a pressure sensitive film surrounding the protruding portion, a first optical anti-reflection film is deposited on a surface of the protruding portion, and the first optical anti-reflection film, the protruding portion, the pressure sensitive film, the first reflective surface, and the second reflective surface are concentric. The upper surface of the first substrate is a pressure bearing side. By means of the film-island structure facing the pressure bearing side, an optical path can be increased by increasing a thickness of the protruding portion by means of a high refractive index of silicon of the protruding portion, to attenuate light penetrating through the first reflective surface, thereby reducing the process difficulty of the optical anti-reflection film deposited on the surface of the protruding portion and the requirements for light transmittance of the optical anti-reflection film, better eliminating the influences of disturbance of multi-interface reflected light for the F-P interference cavity, achieving more excellent spectral characteristics of the multi-beam F-P interference cavity, and reducing pressure monitoring noise of the vacuum microcavity interferometer chip. In a case where a semi-reflection demodulation method is adopted, the reflective index of the first reflective surface is set as non-total reflection, which is less than 50%, and more than 50% of light will be transmitted into the protruding portion from the first reflective surface. In a case where the thickness of the protruding portion is small, this part of transmitted light is less attenuated, it is necessary to set the first optical anti-reflection film at higher light transmittance, or even at the light transmittance of 99% or above accordingly, and the requirements for the process and cost of the first optical anti-reflection film are high. Meanwhile, by orienting the film-island structure toward the pressure bearing side, the empty cavity volume of the F-P interference cavity can be reduced, so as to reduce air therein, and reduce the area of the getter films; and meanwhile, after the three layers of substrates are bonded through silicon-glass-silicon, geometric dimensions of the protruding portion and the pressure sensitive film of the film-island structure and a border on an outer side of the pressure sensitive film can be selectively processed, thereby flexibly adjusting the sensitivity of the vacuum microcavity interferometer chip.

Preferably, the protruding portion is of a cylindrical structure, and the pressure sensitive film has a circular area. This structure is conducive to achieving uniform force bearing in fluid media such as gas and liquid, the high-pressure bearing capacity of the chip is improved, and the stability of interference spectra between the two reflective surfaces of the F-P interference cavity in the vacuum microcavity interferometer chip under the action of pressure is improved.

Preferably, the first substrate and the third substrate have the same diameter and thickness. Due to the same thickness and diameter, approximately symmetric structures about the second substrate are formed. Since the first substrate and the third substrate are both silicon wafers and have the same temperature coefficient, the three layers of substrates have good stress matching characteristics, the whole vacuum microcavity interferometer chip can have an extremely low temperature coefficient, bending deformation of a center of the vacuum microcavity interferometer chip is reduced, and it is ensured that the two reflective surfaces of the F-P optical interference cavity under the action of full-range pressure are kept relatively parallel, which is conducive to achieving high stability of a zero-point output of the vacuum microcavity interferometer chip through good stress matching.

Preferably, the second substrate is larger than the first substrate and the third substrate, and the dimension of the second substrate may be the length or side length of the substrate, which specifically depends on the shape of the second substrate, such that when the sensor is manufactured by using the vacuum microcavity interferometer chip, an exposed surface is formed based on that the second substrate is larger than the first substrate and the third substrate in boundary dimension, and bonded or welded, and fixed to a sensor housing, and the first substrate, the third substrate, and the optical fiber collimator are not in contact with the sensor housing. Stress isolation among the film-island structure of the vacuum microcavity interferometer chip, the optical fiber collimator on the third substrate, and the sensor housing is achieved, when the sensor housing is subject to force or vibration, the force or vibration will be directly transmitted to the second substrate, the first substrate and the third substrate will vibrate overall since they are arranged on two sides of the second substrate and have approximately symmetric structures, no stress is applied to the film-island structure and the optical fiber collimator on the third substrate, thereby ensuring no change in the zero-point output of the vacuum microcavity interferometer chip before and after fastened mounting of machinery on site or during external force impact.

The present application further relates to an ultrahigh-precision optical pressure sensor, including a sensor housing and a chip mounting seat arranged in the sensor housing. The vacuum microcavity interferometer chip is in fixed contact with the chip mounting seat only through the second substrate. By means of the structure, stress isolation among the film-island structure of the vacuum microcavity interferometer chip, the optical fiber collimator on the third substrate, and the sensor housing is achieved, when the sensor housing is subject to force or vibration, the force or vibration will be directly transmitted to the second substrate, the first substrate and the third substrate will vibrate overall since they are arranged on two sides of the second substrate and have approximately symmetric structures, and no stress is applied to the film-island structure and the optical fiber collimator on the third substrate, thereby ensuring no change in the zero-point output of the vacuum microcavity interferometer chip before and after fastened mounting of machinery on site or during external force impact.

The present application further relates to a manufacturing method of the vacuum microcavity interferometer chip. A first substrate is selected as a silicon-on-insulator (SOI) silicon wafer (three-layer structure of top silicon-buried oxygen layer-bottom silicon). The manufacturing method includes the steps: S1. a concave cavity is formed in one surface of the first substrate through an etching and/or potassium Hydroxide (KOH) corrosion process, and a first reflective surface is arranged on a surface, in the concave cavity, of the first substrate; a film-island structure is formed on the other surface of the first substrate through etching and/or KOH etching, a surface of a protruding portion is an original polished surface, the protruding portion and a border have the same thickness, and a first optical anti-reflection film is deposited on the protruding portion; forming the film-island structure in this step is not necessary, and since the film-island structure is arranged on the upper surface of the first substrate, the film-island structure can be formed in the last step; S2. vent holes are formed in a second substrate (glass wafer with two polished surfaces) through through-etching, and a second reflective surface is deposited at a position, corresponding to the first reflective surface, of one surface of the second substrate; a second optical anti-reflection film is deposited at a position, corresponding to a mounting hole, of the other surface of the second substrate; S3. the mounting hole for mounting an optical fiber collimator is formed in a third substrate (ultraflat double-surface-polished silicon wafer); a counterbored hole and an annular cavity are formed in a surface, facing the second substrate, of the third substrate, where the area of the counterbored hole is greater than that of the second optical anti-reflection film, thereby preventing the second optical anti-reflection film from affecting the bonding quality of the second substrate and the third substrate; a sunken groove is etched in an opening of the annular cavity; getter films are deposited on a surface of the annular cavity; and S4. the first substrate, the second substrate, and the third substrate are bonded through a silicon-glass-silicon three-layer bonding or dielectric layer bonding technology at a bonding temperature of 300°C-400°C, where since a getter usually needs to be thermally activated after being deposited, an activation temperature is usually 300°C or above, and the getter films can be activated at the same time of bonding, thereby eliminating the need to activate the getter films after device manufacturing; and the bonding temperature of silicon-glass-silicon is usually selected to be less than 400°C, such that it can be ensured that an optical film with temperature resistance of more than 500°C manufactured after deposition of an optical dielectric material in the chip is not affected.

Preferably, the manufacturing method further includes a step S5. After the three layers of substrates are bonded through silicon-glass-silicon, respective monocrystalline silicon thicknesses of the protruding portion and the pressure sensitive film of the film-island structure are measured in real time, and the protruding portion and the pressure sensitive film are selectively processed under control. Geometric dimensions of the protruding portion and the pressure sensitive film of the film-island structure and the border on the outer side of the pressure sensitive film can be selectively processed, thereby flexibly adjusting the sensitivity of the pressure sensitive chip.

Preferably, the manufacturing method further includes a step S6. After the step S5 is completed, the first optical anti-reflection film is deposited on the protruding portion. The first optical anti-reflection film is deposited after the dimension of the film-island structure is selectively processed, thereby reducing the influences of multi-interface reflected stray light on the F-P interference cavity.

The present disclosure aims to provide the high-precision vacuum microcavity interferometer chip based on a vacuum microcavity multi-beam interferometer principle, the manufacturing method, and the sensor of the high-precision vacuum microcavity interferometer chip. By separating the multi-beam F-P interference cavity for pressure sensitivity and detection from getter cavities within the sensitive chip, and connecting both through the vent holes, the area of the pressure sensitive film and the area of the getter can be independently adjusted according to requirements. The projections of the annular cavity and the F-P interference cavity on the horizontal plane at least partially overlap, thereby reducing the radial dimension of the vacuum microcavity interferometer chip, ensuring that the area of the pressure sensitive film in the chip with the same radial dimension is large enough during pressure measurement, gettering gas in the F-P optical interference cavity, improving the precision of the sensor during pressure measurement, and meeting the requirements for ultrahigh-precision pressure measurement. The situation that activated getter particles enter the F-P interference cavity, affecting the measurement reliability of the vacuum microcavity interferometer chip is avoided through corresponding structures. The exposed surface is formed based on that the second substrate of the MEMS vacuum microcavity interferometer chip is larger than the first substrate and the third substrate in boundary dimension, or adhesion or welded fixation with the sensor housing is achieved through a glass protective tube, the first substrate, the third substrate, and the optical fiber collimator are not connected with the sensor housing through welding flux or adhesives, and therefore stress isolation among the sensitive structure and the optical fiber collimator of the MEMS vacuum microcavity interferometer chip, and a packaging position and the pressure sensor housing of the chip is achieved. The chip is of a three-layer bonding structure, and a plurality of structures and materials such as the pressure sensitive film, the F-P interference cavity, and the getter are integrated and miniaturized. The getter films are activated in the bonding process, the manufacturing process of the sensor is simplified, and the getter films are activated without independently consuming energy. By means of the film-island structure facing the pressure bearing side, the volume in the F-P interference cavity can be reduced, so as to reduce the volume thereof and air therein, and reduce the area of the getter films; and meanwhile, after the three layers of substrates are bonded through silicon-glass-silicon, geometric dimensions of the protruding portion and the pressure sensitive film of the film-island structure and the border on the outer side of the pressure sensitive film can be selectively processed, thereby flexibly adjusting the sensitivity of the vacuum microcavity interferometer chip.

### BRIEF DESCRIPTION OF THE DRAWINGS

FIG. 1 is a schematic structural diagram of a vacuum microcavity interferometer chip according to the present application;
FIG. 2 is a second schematic structural diagram of a vacuum microcavity interferometer chip according to the present application;
FIG. 3 is a third schematic structural diagram of a vacuum microcavity interferometer chip according to the present application;
FIG. 4 is a top view of a second substrate according to the present application;
FIG. 5 is a bottom view of a second substrate according to the present application;
FIG. 6 is a top view of a third substrate according to the present application;
FIG. 7 is a schematic structural diagram of an ultrahigh-precision optical pressure sensor according to the present application; and
FIG. 8 is a schematic diagram of a local structure of an ultrahigh-precision optical pressure sensor according to the present application.

Brief description of reference signs:
1-First substrate; 11-F-P interference cavity; 12-first reflective surface; 13-second reflective surface; 14-pressure sensitive film; 15-first optical anti-reflection film; 2-second substrate; 21-vent hole; 22-step portion; 23-second optical anti-reflection film; 3-third substrate; 31-annular cavity; 32-getter film; 33-first accommodating space; 34-second accommodating space; 41-sensor housing; and 42-chip mounting seat.

### DETAILED DESCRIPTION OF THE EMBODIMENTS

In order to more clearly explain the embodiments of the present disclosure or the technical solutions of the prior art, the drawings needed in the description of the embodiments or the prior art will be briefly described below. Apparently, the drawings in the following description are merely some embodiments of the present disclosure. For those ordinarily skilled in the art, other drawings can be obtained in accordance with these drawings without involving any inventive effort.

For the sake of simplicity of the drawings, the parts relevant to the present disclosure are shown only schematically in the drawings, which do not represent the actual structure thereof as a product. Additionally, in order to simplify the drawings for ease of understanding, components having the same structure or function in some drawings are shown schematically with only one of them, or only one of them is labeled. Herein, "a" means not only "only this one" but also "more than one" case.

It should also be understood that the term "and/or" used in the specification and the appended claims of the present application means any combination of one or more of associated listed items and all possible combinations, and includes these combinations.

Here, it needs to be noted that unless otherwise clearly specified and limited, terms "disposed", "coupled", and "connected" should be broadly understood. For example, the terms may refer to fixed connection, detachable connection or integrated connection; the terms may refer to mechanical connection or electric connection; and the terms may refer to direct connection, indirect connection through an intermediate medium, or communication between interiors of two elements. For a person of ordinary skill in the art, the specific meaning of the above terms in the present disclosure can be understood according to specific circumstances.

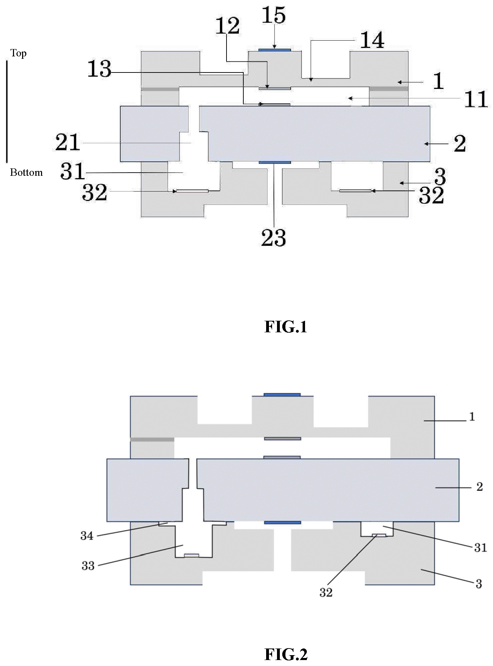

The present disclosure provides a vacuum microcavity interferometer chip, a manufacturing method, and an ultrahigh-precision optical pressure sensor to overcome the technical defects of optical fiber pressure sensors in the prior art. The vacuum microcavity interferometer chip includes a first substrate 1, a second substrate 2, and a third substrate 3. Preferably, the first substrate 1 and the third substrate 3 are silicon substrates or silicon nitride wafers or substrates with other similar functions, the second substrate 2 is a glass wafer or a sapphire wafer or a substrate with other similar functions and high light transmittance, and the three substrates are bonded together through silicon-glass-silicon bonding or corresponding dielectric layers, such as BCB glue, gold layers or glass paste, please refer to FIG. 1 for details. A concave cavity is etched in a lower surface of the first substrate 1, when the first substrate 1 and the second substrate 2 are bonded, the concave cavity is formed as an F-P interference cavity 11, a first reflective surface 12 is arranged on a surface, in the F-P interference cavity 11, of the first substrate 1, a second reflective surface 13 is arranged on a surface, in the F-P interference cavity 11, of the second substrate 2, an annular cavity 31 is formed in an upper surface of the third substrate 3, getter films 32 are deposited on at least one surface in the annular cavity 31, at least one vent hole 21 is formed in the second substrate 2, and the vent hole 21 communicates with the F-P interference cavity 11 and the annular cavity 31; projections of the annular cavity 31 and the F-P interference cavity 11 on a horizontal plane at least partially overlap; and a mounting hole for an optical fiber collimator is formed in the center of the third substrate 3. By means of the above structure, the annular cavity 31 is connected with the F-P interference cavity 11 through the vent holes 21, such that the annular cavity 31 where the getter films 32 are deposited is independently formed, thereby ensuring that the annular cavity 31 has enough surface area to absorb residual gas in the F-P optical interference cavity. In addition, since the annular cavity 31 and the F-P interference cavity 11 are not arranged on the same substrate, the projections of the annular cavity 31 and the F-P interference cavity 11 in this structure on the horizontal plane at least partially overlap, thereby reducing the radial dimension of the vacuum microcavity interferometer chip and meeting mounting requirements of special application scenarios. It is also ensured that the area of the pressure sensitive film 14 in the chip with the same radial dimension is large enough during pressure measurement, gas in the F-P optical interference cavity is gettered, the precision of the sensor during pressure measurement is improved, and therefore the requirements for ultrahigh-precision pressure measurement are met.

In a further preferred embodiment, a width of the annular cavity 31 is greater than a diameter of the vent holes 21, such that a small quantity of particles will be generated when the getter films 32 are heated or vibrated externally, the particles are blocked by the second substrate 2, and the situation that the particles enter the F-P interference cavity 11 through the vent holes 21 to contaminate the F-P optical interference cavity and potentially lead to spectral deterioration, greatly affecting the measurement of the optical sensor, especially causing device failure in severe cases is avoided.

In a further preferred embodiment, a first accommodating space 33 is arranged at a position, corresponding to the vent holes 21, of the annular cavity 31, please refer to FIG. 2 for details; the first accommodating space 33 is a deposition groove formed in a bottom of the annular cavity 31 and used for accommodating a small quantity of particles formed by the getter films 32, and a depth of the first accommodating space 33 is greater than that of the annular cavity 31, so as to further prevent the particles from entering the F-P interference cavity 11 through the vent holes 21. It is to be understood that the first accommodating space 33 is of a groove structure arranged on a bottom wall of the annular cavity.

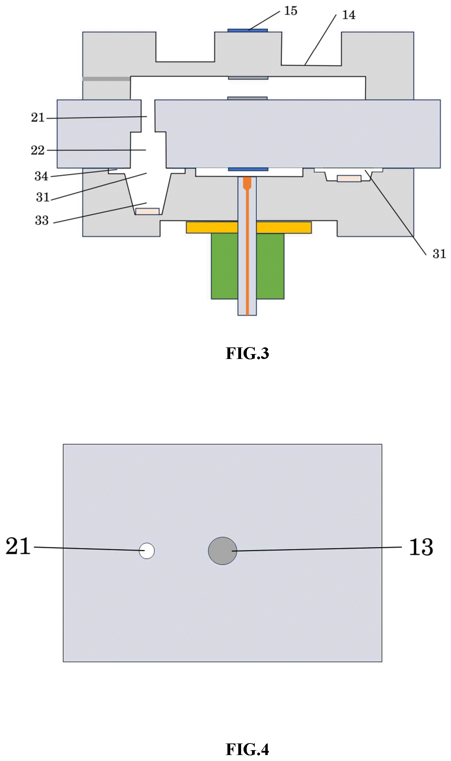

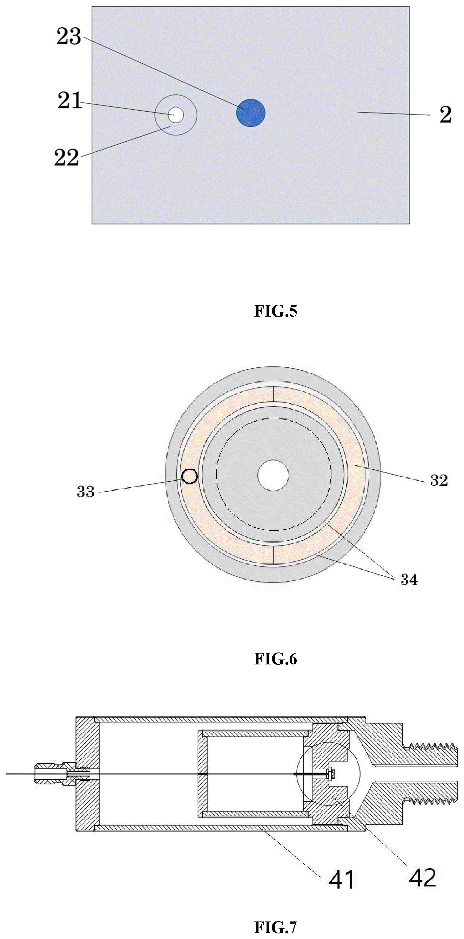

In a further preferred embodiment, a sunken groove is formed in an opening of the annular cavity 31, the sunken groove has a circular structure, the circular structure may be a sunken groove only surrounding the first accommodating space 33, that is, the sunken groove and the first accommodating space 33 have the same center, as shown in FIG. 2. Or preferably, the sunken groove of the circular structure may be a sunken groove in a circumferential direction of the opening of the annular cavity 31, as shown in FIG. 3 and FIG. 6, that is, the sunken groove and the annular cavity 31 have the same center. The latter sunken groove has a better accommodating space, particles generated by the getter films are approximately distributed circumferentially since the getter films are arranged in the annular cavity circumferentially, and the particles can be better accommodated and collected in the circumferential direction of the getter films, thereby reducing movement of free particles. The sunken groove and the bottom face of the second substrate 2 cooperate to form a second accommodating space 34, when the vacuum microcavity interferometer chip is subject to vibration or inclining during use, since the diameter of the vent holes 21 is less than the width of the annular cavity 31, the particles move towards the vent holes 21 along a side wall of the first accommodating space 33, and are blocked by the bottom face of the second substrate 2 to enter the second accommodating space 34, and the situation that the particles enter the F-P interference cavity 11 through the vent holes 21 to contaminate an optical film in the F-P interference cavity 11, resulting in device failure is further avoided.

In a further preferred embodiment, the annular cavity 31 includes two peripheral walls and a bottom wall, at least one peripheral wall of the annular cavity 31 inclines, a bottom width of the annular cavity 31 is less than an opening width of the annular cavity 31 since the peripheral walls incline, and a difference between the diameter of the vent holes 21 and the opening width of the annular cavity 31 is increased by the inclining peripheral walls. Therefore, the particles can be better prevented from entering the vent holes 21 from the annular cavity 31, and meanwhile the particles can be better guided to enter the second accommodating space 34.

In a further preferred embodiment, a side wall of the first accommodating space 33 and the two peripheral walls of the annular cavity 31 are smoothly and continuously connected, and the particles can be directly guided into the second accommodating space by the smooth and continuous side wall and peripheral walls 34.

In a further preferred embodiment, a step portion 22 is arranged on the second substrate, a diameter of the step portion 22 is greater than that of the vent holes 21, as shown in FIG. 4 and FIG. 5, and the step portion is arranged between the vent holes 21 and the annular cavity 31. By using the diameter change in the step portion 22 and the vent holes 21, the trace quantity of particles stored in the first accommodating space and the second accommodating space are blocked, further being prevented from entering the F-P interference cavity.

In a further preferred embodiment, a film-island structure is formed on an upper surface of the first substrate 1, the film-island structure includes a protruding portion formed by a counterbored hole and a pressure sensitive film 14 surrounding the protruding portion, a first optical anti-reflection film 15 is deposited on a surface of the protruding portion, and the first optical anti-reflection film 15, the protruding portion, the pressure sensitive film 14, the first reflective surface 12, and the second reflective surface 13 are concentric. The upper surface of the first substrate 1 is a pressure bearing side. By orienting the film-island structure toward the pressure bearing side, an optical path can be increased by increasing a thickness of the protruding portion by means of a high refractive index of silicon of the protruding portion, to attenuate light penetrating through the first reflective surface 12, thereby reducing the process difficulty of the optical anti-reflection film deposited on the surface of the protruding portion and the requirements for light transmittance of the optical anti-reflection film, better eliminating the influences of disturbance of multi-interface reflected light for the F-P interference cavity 11, achieving more excellent spectral characteristics of the multi-beam F-P interference cavity 11, and reducing pressure monitoring noise of the vacuum microcavity interferometer chip. In a case where a semi-reflection demodulation method is adopted, the reflective index of the first reflective surface 12 is set as non-total reflection, which is less than 50%, and more than 50% of light will be transmitted into the protruding portion from the first reflective surface 12. In a case where the thickness of the protruding portion is small, this part of transmitted light is less attenuated, it is necessary to set the first optical anti-reflection film 15 at higher light transmittance, or even at the light transmittance of 99% or above accordingly, and the requirements for the process and cost of the first optical anti-reflection film 15 are high. Meanwhile, by orienting the film-island structure toward the pressure bearing side, the empty cavity volume of the F-P interference cavity can be reduced, so as to reduce air therein, and reduce the area of the getter films 32; and meanwhile, after the three layers of substrates are bonded through silicon-glass-silicon, geometric dimensions of the protruding portion and the pressure sensitive film 14 of the film-island structure and a border on an outer side of the pressure sensitive film 14 can be selectively processed, thereby flexibly adjusting the sensitivity of the vacuum microcavity interferometer chip.

In a preferred embodiment, the protruding portion is of a cylindrical structure, and the pressure sensitive film 14 has a circular area. This structure is conducive to achieving uniform force bearing in fluid media such as gas and liquid, the high-pressure bearing capacity of the chip is improved, and the stability of interference spectra between the two reflective surfaces of the F-P interference cavity 11 in the vacuum microcavity interferometer chip under the action of pressure is improved.

In a preferred embodiment, the first substrate 1 and the third substrate 3 have the same diameter and thickness. Due to the same thickness and diameter, approximately symmetric structures about the second substrate 2 are formed, please refer to FIG. 3 for details. Since the first substrate 1 and the third substrate 3 are both silicon wafers and have the same temperature coefficient, the three layers of substrates have good stress matching characteristics, the whole vacuum microcavity interferometer chip can have an extremely low temperature coefficient, bending deformation of a center of the vacuum microcavity interferometer chip is reduced, and it is ensured that the two reflective surfaces of the F-P optical interference cavity under the action of full-range pressure are kept relatively parallel, which is conducive to achieving high stability of a zero-point output of the vacuum microcavity interferometer chip through good stress matching.

In a preferred embodiment, the second substrate 2 is larger than the first substrate 1 and the third substrate 3, such that when the sensor is manufactured by using the vacuum microcavity interferometer chip, an exposed surface is formed based on that the second substrate 2 is larger than the first substrate 1 and the third substrate 3 in boundary dimension, and bonded or welded, and fixed to a sensor housing 41, and the first substrate 1, the third substrate 3, and the optical fiber collimator are not in contact with the sensor housing 41. Stress isolation among the film-island structure of the vacuum microcavity interferometer chip, the optical fiber collimator on the third substrate 3, and the sensor housing 41 is achieved, when the sensor housing 41 is subject to force or vibration, the force or vibration will be directly transmitted to the second substrate 2, the first substrate 1 and the third substrate 3 will vibrate overall since they are arranged on two sides of the second substrate 2 and have approximately symmetric structures, and no stress is applied to the film-island structure and the optical fiber collimator on the third substrate 3, thereby ensuring no change in the zero-point output of the vacuum microcavity interferometer chip before and after fastened mounting of machinery on site or during external force impact.

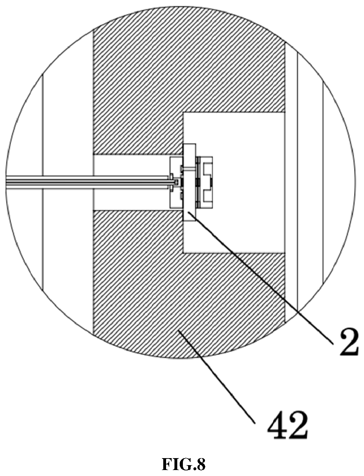

The present application further relates to an ultrahigh-precision optical pressure sensor, including the sensor housing 41 and a chip mounting seat 42 arranged in the sensor housing 41, as shown in FIG. 7 and FIG. 8, and the vacuum microcavity interferometer chip is in fixed contact with the chip mounting seat 42 only through the second substrate 2. By means of the structure, stress isolation among the film-island structure of the vacuum microcavity interferometer chip, the optical fiber collimator on the third substrate 3, and the sensor housing 41 is achieved, when the sensor housing 41 is subject to force or vibration, the force or vibration will be directly transmitted to the second substrate 2, the first substrate 1 and the third substrate 3 will vibrate overall since they are arranged on two sides of the second substrate 2 and have approximately symmetric structures, and no stress is applied to the film-island structure and the optical fiber collimator on the third substrate 3, thereby ensuring no change in the zero-point output of the vacuum microcavity interferometer chip before and after fastened mounting of machinery on site or during external force impact.

The present application further relates to a manufacturing method of the vacuum microcavity interferometer chip. A first substrate 1 is selected as an SOI silicon wafer (three-layer structure of top silicon-buried oxygen layer-bottom silicon). The manufacturing method includes the steps: S1. a concave cavity is formed in one surface of the first substrate 1 through an etching and/or KOH etching process, and a first reflective surface 12 is arranged on a surface, in the concave cavity, of the first substrate 1; a film-island structure is formed on the other surface of the first substrate through etching and/or KOH etching, a surface of a protruding portion is an original polished surface, the protruding portion and a border have the same thickness, and a first optical anti-reflection film 15 is deposited on the protruding portion; forming the film-island structure in this step is not necessary, and since the film-island structure is arranged on the upper surface of the first substrate, the film-island structure can be formed in the last step; S2. vent holes 21 are formed in a second substrate 2 (glass wafer with two polished surfaces) through through-etching, and a second reflective surface 13 is deposited at a position, corresponding to the first reflective surface 12, of one surface of the second substrate 2; a second optical anti-reflection film 23 is deposited at a position, corresponding to a mounting hole, of the other surface of the second substrate 2; S3. the mounting hole for mounting an optical fiber collimator is formed in a third substrate 3 (ultraflat double-surface-polished silicon wafer); a counterbored hole and an annular cavity 31 are formed in a surface, facing the second substrate 2, of the third substrate 3, where the area of the counterbored hole is greater than that of the second optical anti-reflection film 23, thereby preventing the second optical anti-reflection film 23 from affecting the bonding quality of the second substrate 2 and the third substrate 3; a sunken groove is etched in an opening of the annular cavity 31; getter films 32 are deposited on a surface of the annular cavity 31; it is to be understood that steps S1-S3 have no sequential relationship; and S4. the first substrate 1, the second substrate 2, and the third substrate 3 are bonded through a silicon-glass-silicon three-layer bonding technology at a bonding temperature of 300°C-400°C, where since a getter usually needs to be thermally activated after being deposited, an activation temperature is usually 300°C or above, and the getter films 32 can be activated at the same time of bonding, thereby eliminating the need to activate the getter films 32 after device manufacturing; and the bonding temperature of silicon-glass-silicon is usually selected to be less than 400°C, such that it can be ensured that an optical film with temperature resistance of more than 500°C manufactured after deposition of an optical dielectric material in the chip is not affected.

In a further preferred embodiment, the manufacturing method further includes a step S5. After the three layers of substrates are bonded, respective monocrystalline silicon thicknesses of the protruding portion and the pressure sensitive film 14 of the film-island structure are measured in real time, and the protruding portion and the pressure sensitive film are selectively processed under control. Geometric dimensions of the protruding portion and the pressure sensitive film 14 of the film-island structure and the border on the outer side of the pressure sensitive film 14 can be selectively processed, thereby flexibly adjusting the sensitivity of the vacuum microcavity interferometer chip.

Preferably, the manufacturing method further includes a step S6. After the step S5 is completed, the first optical anti-reflection film is deposited on the protruding portion. The first optical anti-reflection film is deposited after the dimension of the film-island structure is selectively processed, thereby reducing the influences of multi-interface reflected stray light on the F-P interference cavity.

## Claims

1. A vacuum microcavity interferometer chip, comprising a first substrate, a second substrate, and a third substrate, wherein the three substrates are bonded together; **characterized in that** a concave cavity is formed in a lower surface of the first substrate by etching, after the first substrate and the second substrate are bonded together, the concave cavity is formed as an F-P interference cavity, a first reflective surface is arranged on a surface, in the F-P interference cavity, of the first substrate, a second reflective surface is arranged on a surface, in the F-P interference cavity, of the second substrate, an annular cavity is formed in the third substrate, a getter film is deposited on at least one surface in the annular cavity, at least one vent hole is formed in the second substrate, and the vent hole communicates with the F-P interference cavity and the annular cavity; the projections of the annular cavity and the F-P interference cavity on a horizontal plane at least partially overlap each other; and a mounting hole for an optical fiber collimator is formed in the center of the third substrate.

2. The vacuum microcavity interferometer chip according to claim 1, **characterized in that** a width of the annular cavity is greater than the diameter of the vent hole.

3. The vacuum microcavity interferometer chip according to claim 1 or 2, **characterized in that** a first accommodating space is formed at a position, corresponding to the vent hole, of the annular cavity, the first accommodating space is a deposition groove formed in a bottom of the annular cavity and used for accommodating particles formed by the getter film, and a depth of the first accommodating space is greater than that of the annular cavity.

4. The vacuum microcavity interferometer chip according to claim 2, **characterized in that** a sunken groove is formed in an opening of the annular cavity, the sunken groove has a circular structure, and the sunken groove and a bottom face of the first substrate cooperate to form a second accommodating space.

5. The vacuum microcavity interferometer chip according to claim 1 or 2, **characterized in that** the annular cavity comprises two peripheral walls and a bottom wall, at least one peripheral wall of the annular cavity inclines, a bottom width of the annular cavity is less than an opening width of the annular cavity since the peripheral walls incline, and the inclined peripheral wall increases a difference between the diameter of the vent hole and the opening width of the annular cavity.

6. The vacuum microcavity interferometer chip according to claim 3, **characterized by** further comprising a second accommodating space arranged on the third substrate, wherein a side wall of the first accommodating space and the two peripheral walls of the annular cavity are smoothly and continuously connected, and the particles can be directly guided into the second accommodating space by the smooth and continuous side wall and peripheral walls.

7. The vacuum microcavity interferometer chip according to claim 1 or 2, **characterized in that** a step portion is arranged on the second substrate, a diameter of the step portion is greater than that of the vent holes, and the step portion is arranged between the vent holes and the annular cavity.

8. The vacuum microcavity interferometer chip according to claim 1 or 2, **characterized in that** a film-island structure is formed on an upper surface of the first substrate, the film-island structure comprises a protruding portion formed by a counterbored hole and a pressure sensitive film surrounding the protruding portion, a first optical anti-reflection film is deposited on a surface of the protruding portion, and the first optical anti-reflection film, the protruding portion, the pressure sensitive film, the first reflective surface, and the second reflective surface are concentric.

9. The vacuum microcavity interferometer chip according to claim 8, **characterized in that** the protruding portion is of a cylindrical structure, and the pressure sensitive film has a circular area.

10. The vacuum microcavity interferometer chip according to claim 1 or 2, **characterized in that** the first substrate and the third substrate have the same diameter and thickness.

11. The vacuum microcavity interferometer chip according to claim 1 or 2, **characterized in that** the second substrate is larger than the first substrate and the third substrate.

12. An ultrahigh-precision optical pressure sensor comprising the vacuum microcavity interferometer chip according to any one of claims 1-11, **characterized by** comprising a sensor housing and a chip mounting seat arranged in the sensor housing, wherein the vacuum microcavity interferometer chip is in fixed contact with the chip mounting seat only through the second substrate.

13. A manufacturing method for manufacturing the vacuum microcavity interferometer chip according to any one of claims 1-11, comprising the steps: S1. forming a concave cavity in one surface of a first substrate through an etching and/or KOH etching process, and arranging a first reflective surface on a surface, in the concave cavity, of the first substrate; forming a film-island structure on the other surface of the first substrate through etching and/or KOH etching, wherein the film-island structure comprises a protruding portion formed by a counterbored hole and a pressure sensitive film surrounding the protruding portion; S2. forming vent holes in a second substrate through through-etching, and depositing a second reflective surface at a position, corresponding to the first reflective surface, of one surface of the second substrate; depositing a second optical anti-reflection film at a position, corresponding to a mounting hole, of the other surface of the second substrate; S3. forming the mounting hole for mounting the optical fiber collimator in a third substrate; arranging an annular cavity in a surface, facing the second substrate, of the third substrate, and etching a sunken groove in an opening of the annular cavity; depositing getter films on a surface of the annular cavity; and S4. bonding the first substrate, the second substrate, and the third substrate through three-layer bonding at 300°C-400°C.

14. The manufacturing method according to claim 13, **characterized by** further comprising a step S5, wherein after three-layer bonding of the substrates, thicknesses of the protruding portion and the pressure sensitive film of the film-island structure are measured in real time, and the protruding portion and the pressure sensitive film are selectively processed under control.

15. The manufacturing method according to claim 14, **characterized by** further comprising a step S6, wherein after the step S5 is completed, a first optical anti-reflection film is deposited on the protruding portion.
